# EUROPEAN PATENT APPLICATION

(11) **EP 2 048 918 A1**
(43) Date of publication of application: **15.04.2009**
(21) Application number: 07118109.3
(22) Date of filing: 09.10.2007
(51) Int. Cl.: H05K 1/00

(54) **Manufacture of a conductive pattern on a plastic component**

(71) Applicant: Nederlandse Organisatie voor toegepast-natuurwetenschappelijk onderzoek TNO, 2628 VK Delft (NL)
(72) Inventor: The designation of the inventor has not yet been filed
(74) Representative: Hatzmann, Martin

(57) **Abstract**

Method for providing a conductive pattern (5) on a plastic component (2) having one or more not-flat areas (3a), comprising providing the conductive pattern on a mainly flat carrier (4), the conductive pattern comprising, for each area (3b) which corresponds to such non-flat area of the plastic component, a pattern area having an extendable shape or design. Next, putting the carrier, including its conductive pattern and one or more extendable sub-patterns, into or onto a mold (1) which is arranged for molding the plastic component. Finally, performing a molding operation in which, in any order, the plastic component is formed and the carrier is, at least partly, shaped in accordance with any not-flat area of the component, the relevant sub-pattern being stretched in accordance with that not-flat area. The extendable sub-pattern may have, at least partly, e.g. a meandering form or the form of an extendable grid.

## Description

The invention refers to a method for providing a conductive pattern on a plastic component having one or more not-flat areas.

Generally known are methods for the manufacture of plastic products or components, comprising filling a mold with a fluid thermoplastic or a thermosetting plastic. A thermoplastic is a material that is plastic or deformable, melts to a liquid when heated and freezes to a brittle, glassy state when cooled sufficiently. Most thermoplastics are high molecular weight polymers whose chains associate through weak van der Waals forces (polyethylene); stronger dipole-dipole interactions and hydrogen bonding (nylon) or even stacking of aromatic rings (polystyrene). Thermoplastic polymers differ from thermosetting polymers (Bakelite; vulcanized rubber) which once formed and cured, can never be remelted and remolded. Many thermoplastic materials are addition polymers; e.g., vinyl chain-growth polymers such as polyethylene and polypropylene. Thermosetting plastics (thermosets) are polymer materials that cure, through the addition of energy, to a stronger form. The energy may be in the form of heat (generally above 200 degrees Celsius), through a chemical reaction (two-part epoxy, for example), or irradiation. In line of these definitions, within the scope of this invention the term plastic or plastics will include all kinds of thermoplastic and thermosetting plastics.

Injection molding machines, also known as presses, hold the molds in which the components are shaped. A high pressure keeps the mold closed during the injection process. Mold is the common term used to describe the production tooling used to produce plastic parts in injection molding. Traditionally, molds have been expensive to manufacture. They were usually only used in mass production where thousands of parts were being produced. Molds are typically constructed from hardened steel, pre-hardened steel, aluminium, and/or a beryllium-copper alloy. Injection molds separate into at least two halves (called the core and the cavity) to permit the part to be extracted. In general the shape of a part must not cause it to be locked into the mold. For example, sides of objects typically cannot be parallel with the direction of draw (the direction in which the core and cavity separate from each other). They are angled slightly (draft), and examination of most plastic household objects will reveal this.

Parts that are "bucket-like" tend to shrink onto the core while cooling, and after the cavity is pulled away. Pins are the most popular method of removal from the core, but air ejection, and stripper plates can also be used depending on the application. Most ejection plates are found on the moving half of the tool, but they can be placed on the fixed half. More complex parts are formed using more complex molds, which may have movable sections called slides which are inserted into the mold to form features that cannot be formed using only a core and a cavity. Slides are then withdrawn to allow the part to be released.

Besides injection molding, other plastic molding processes may be of interest and applicable within the scope of the present invention, including e.g. any type of thermoforming process, like blow molding, vacuum molding etc.

Thermoforming is a manufacturing process for thermoplastic sheet, foil or film (hereinafter also summarized under the term foil). The sheet, foil or film is heated between infrared, natural gas, or other heaters to its forming temperature. Then it is stretched into or onto (over) a temperature-controlled, single-surface mold. Cast or machined aluminum is the most common mold material, although epoxy, wood and structural foam tooling are sometime used for low volume production. The sheet is held against the mold surface unit until cooled. The formed part is then trimmed from the sheet. There are several categories of thermoforming, including vacuum forming, pressure forming, twin-sheet forming, drape forming, free blowing, and simple sheet bending.

Some (injection or other) molds allow previously manufactured parts to be inserted to allow a layer to form upon or within the first part. This is often referred to as overmolding or foil overmolding where it refers to overmolding a foil (incl. sheet or film).

It is generally known that in electronics, printed circuit boards, or PCBs, are used to mechanically support and electrically connect electronic components using conductive pathways or traces (the latter term will be used hereinafter), etched from copper sheets laminated onto a non-conductive substrate. Alternative names are printed wiring board (PWB), and etched wiring board. Populating the board with electronic components forms a printed circuit assembly (PCA), also known as a printed circuit board assembly (PCBA). PCBs are rugged, inexpensive, and can be highly reliable. They require much more layout effort and higher initial cost than either wire-wrapped or point-to-point constructed circuits, but are much cheaper, faster, and consistent in high volume production. The vast majority of printed circuit boards are made by adhering a layer of copper over the entire substrate, sometimes on both sides, (creating a "blank PCB") then removing unwanted copper after applying a temporary mask (e.g. by etching), leaving only the desired copper traces. A few PCBs are made by adding traces to the bare substrate (or a substrate with a very thin layer of copper) usually by a complex process of multiple electroplating steps. The boards may use organic or inorganic base materials in a single or multilayer, rigid or flexible form, thus resulting is rigid of flexible PCBs.

Printed circuits may be integrated into plastic components by means of overmolding (see above) such printed circuits. Where flexible PCBs (having sheet, foil or film type carriers) are used, the foil overmolding process may be applied.

When (foil) overmolding a flexible PCB, a problem arises when the relevant plastic component, to be formed by e.g. injection molding (or other methods), includes one or more not-flat areas. The problem is that, during the (over)molding process, the copper traces in such not-flat areas have to be distorted or deformed. However, the metal traces only can be distorted or deformed to a very small extent, which in many cases will be far too small, e.g. in corner and edge areas of the plastic component, resulting in crack formation in the metal traces. Besides, another problem occurs: the deformation of a heated and thus softened plastic will require much less force than the force required for the deformation of the metal. When the plastic is deformed, e.g. by means of compressed air or vacuum, this could result in that the metal traces not deform properly along the surface of the plastic, but penetrate into the plastic itself. This would result in an ugly, unequally deformed product.

It is thus an aim of the invention to provide a conductive pattern on a plastic component having one or more not-flat areas, where the material characteristics of the trace pattern as such is not capable to follow the curves of the surface of the component to be made. It is noted that it is presumed that de foil or other carrier to which the conductive traces have been attached, is capable as such to follow the relevant surface curves, all the more as such carrier preferably will be made of a (more or less) thermoplastic material, which, e.g. starting from a mainly flat shape, will be deformable very well at the temperature at which the proper molding is performed.

According to the invention next steps are preferred for the manufacture of a plastic component having one or more not-flat areas and including conductive traces on its (thus curved) surface:
- providing the conductive pattern on a mainly flat carrier (e.g. any type of flexible PCB), the conductive pattern comprising, for each area which corresponds to such non-flat area of the plastic component, a pattern area having an extendable shape or design, called extendable sub-pattern or sub-pattern hereinafter;
- putting the carrier, including its conductive pattern and said one or more extendable sub-patterns, into or onto a mold which is arranged for molding the plastic component;
- performing a molding operation in which the plastic component is formed and the carrier is, at least partly, shaped in accordance with any not-flat area of the component, any extendable sub-pattern being stretched in accordance with the relevant not-flat area.

The extendable sub-pattern may have, at least partly, a meandering form, the form of an extendable grid or any form having extendable characteristics.

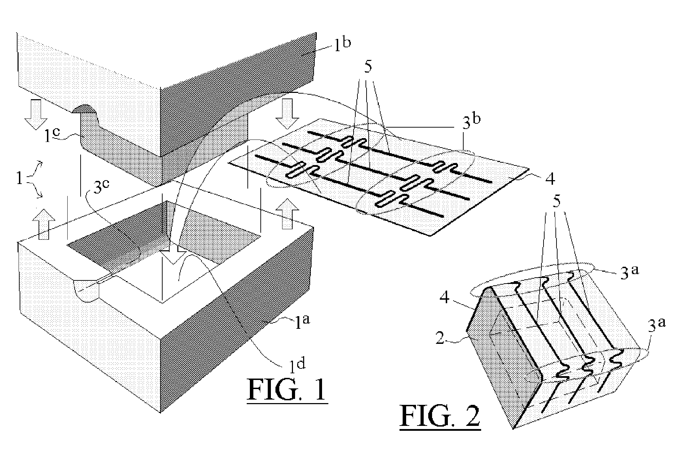

Figure 1 shows an illustration of an exemplary embodiment of the method according to the present invention; Figure 2 shows a product made by means of the exemplary embodiment of the method.

Figure 1 shows schematically a mold 1, comprising two molding parts 1a,1b. A plastic compound can be entered into the space between both molding parts in their closed position (see vertical arrows). The intended product, shown in figure 2, will be formed by the space between both mold parts, in this case having the shape of a hollow body, defined by the shape of the mould core 1c of mold part 1b. The outside surface of the product 2 is defined by the shape of the cavity 1d in mold parts 1a. This (simple) product 2 comprises flat areas as well as non-flat (curved) areas 3a. The intended product 2 is provided of a layer 4 having a conductive pattern (traces) 5 on its surface, viz. extending over its flat surface areas as well as over its non-flat surface areas 3a.

The following steps are preformed to manufacture the product 2:
- providing the conductive pattern 5 on the mainly flat carrier 4, the conductive pattern comprising, for each area 3b which corresponds to a non-flat area 3a of the plastic component 2, a pattern area having an extendable shape or design, viz. formed by a meandering conductor pattern in this exemplary embodiment, residing within the areas 3b;
- putting the (flexible, flat) carrier 4, including its conductive pattern 5 and one or more extendable sub-patterns (in the areas 3b), into the mold 1 which is arranged for molding the plastic component 2;
- performing a molding operation in which, in any order:

- the plastic component is formed, viz. by injecting molten plastic compound into the (closed mold) and
- shaping the (flexible) carrier 4, at least partly, in accordance with the not-flat areas of the component, defined by corresponding curved areas 3c in the cavity 1d of mold part 1a (note: the carrier 5 has to be inserted between the mold parts 1a and 1b having, in figure 1, the conductors 5 on the underside of the carrier 4).

The carrier 4 - which may be pre-heated to facilitate its deformation - may be pressed to the bottom of the cavity 1d e.g. by means of air pressure supplied from above and/or vacuum from the bottom side. During this bending or further deformation of the carrier 4 the conductors are easily stretched due to the extendable (meandering) shape of the conductors in the areas 3b, which correspond to the areas 3c in the mold cavity 1d. Instead of a meandering form, the form of an extendable grid or any other extendable conductor shape may be applied.

It is noted that the carrier 4 and its conductors 5 may be applied on the inner surface of the product instead of - as shown in figure 2 - on its outside surface. In that case the carrier 4 is inserted between both mold parts 1a and 1b as well, however, in that case having the conductors 5 upwards, i.e. directed to the mold core 1c. The carrier 4 may be pressed to the core 1c by means of overpressure from the bottom side and/or underpressure (vacuum) from the side of the mold core 1c.

The product 2 may be formed by means of injection molding, as suggested in the exemplary embodiment shown in figure 1, however, may e.g. be manufactured by means of any type thermoforming, e.g. starting from a thermoplastic layer which is heated to its deformation temperature and subsequently stretched into or onto a single-surface mold (e.g. having about the shape of mold part 1a, including a cavity, or mold part 1b, including a core). The layer is held against the mold surface by means of underpressure (vacuum) or overpressure until cooled and is then trimmed from the sheet. The layer may be solely formed by the foil 4 as shown in figure 1, which thus is deformed by heating it and stretching it into a cavity like the cavity 1d or onto a core like core 1c of a single-surface mold having about the shape of mold part 1a or mold part 1brespectively. Alternatively, the layer to be thermoformed (and e.g. starting as a mainly flat layer) may be a separate construction layer, to which foil 4, including conducting traces 5, is to be added (as in the example of figure 1), resulting in a two-layer product (like the product in figure 2), made by simultaneous thermoforming the construction layer and the carrier foil 4, including the conductive traces 5 by stretching them simultaneously into a mold cavity (like cavity 1d) or onto (over) a mold core (like core 1c). Summarizing, any type of molding of thermosetting or thermoplastic material is deemed to be within the scope of the present invention.

## Claims

1. Method for providing a conductive pattern (5) on a plastic component (2) having one or more not-flat areas (3a), comprising
- providing the conductive pattern on a mainly flat carrier (4), the conductive pattern comprising, for each area (3b) which corresponds to such non-flat area of the plastic component, a pattern area having an extendable shape or design;
- putting the carrier, including its conductive pattern and one or more extendable sub-patterns, into or onto a mold (1) which is arranged for molding the plastic component;
- performing a molding operation in which, in any order, the plastic component is formed and the carrier is, at least partly, shaped in accordance with any not-flat area of the component, the relevant sub-pattern being stretched in accordance with that not-flat area.

2. Method according to claim 1, wherein the extendable sub-pattern has, at least partly, a meandering form.

3. Method according to claim 1, wherein the extendable sub-pattern has, at least partly, the form of an extendable grid.

4. Product manufactured by any method of claims 1 through 3.
